(19) Europäisches Patentamt
European Patent Office
Office européen des brevets

(11) Publication number: 0 028 313
B1

(12) # EUROPEAN PATENT SPECIFICATION

(45) Date of publication of patent specification: 25.04.84

(51) Int. Cl.[3]: G 11 C 7/00, G 11 C 17/00

(21) Application number: 80105781.1

(22) Date of filing: 25.09.80

(54) **Integral memory circuit with a single pulse train timing control.**

(30) Priority: 06.11.79 US 91842

(43) Date of publication of application:
13.05.81 Bulletin 81/19

(45) Publication of the grant of the patent:
25.04.84 Bulletin 84/17

(84) Designated Contracting States:
DE FR GB

(56) References cited:
EP - A - 0 012 663
US - A - 3 428 951
US - A - 3 613 055
US - A - 3 678 473
US - A - 3 959 781
US - A - 3 962 686
US - A - 3 969 706
US - A - 4 025 908
US - A - 4 057 787
US - A - 4 161 040

(73) Proprietor: International Business Machines Corporation
Old Orchard Road
Armonk, N.Y. 10504 (US)

(72) Inventor: Brossard, Michael Edward
2414 28th Avenue
N.W., Rochester, Minnesota 55901 (US)
Inventor: Heuer, Dale Arthur
8906 Marathon Road
Longmont, Colorado 80501 (US)
Inventor: Wu, Philip Tung
911 28th Street
N.W. Rochester, Minnesota 55901 (US)

(74) Representative: Grant, Iain Murray
IBM United Kingdom Patent Operations Hursley Park
Winchester, Hants, SO21 2JN (GB)

(56) References cited:
IEEE JOURNAL OF SOLID-STATE CIRCUITS, vol. SC-14, no. 5, October 1979, NEW YORK (US) KUICHI et al.: "A 65 mW 128 K EB-ROM", pages 855-858

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 028 313 B1

(56) References cited:
ELECTRONICS, vol. 51, no. 7, March 30, 1978, NEW YORK (US) WILSON: "Cell Layout Boosts Speed of Low-power 64 K ROM", pages 96-99 GREENE: "Dense, interchangeable ROMs work with fast microprocessors" pages 104-107
SEMICONDUCTOR MEMORY BOOK, INTELWILEY 1978, NEW YORK (US) COE: "Designing with 16K Dynamic RAMs", pages 131-138
IEEE JOURNAL OF SOLID-STATE CIRCUITS, vol. SC13, no. 5, October 1978, NEW YORK (US) WADA et al.: "A 64 K x 1 Bit Dynamic ED-MOS RAM", pages 600-606
ELECTRONICS, vol. 49, no. 10, May 13, 1976, NEW YORK (US) KUO et al.: "16-K RAM built with Proven Process may Offer high start-up Reliability", pages 81-85

# Integral memory circuit with a single pulse train timing control

The present invention relates to integral memory circuits and concentrates on the timing and output latching therein.

Prior output latch circuits have commonly entailed circuit delays in establishing the validity of the output signal as the latch was set. Even so called delayless latch circuits (see for example U.S. Patent 3,846,643) were often only a matter of degree as some of the current used to establish the output signal was robbed to force the latch. Either of these conditions imposes circuit delays that compromise the speed of memory access and thereby lengthens the cycle time of the memory device and complicates the timing. One kind of arrangement that will provide "output speed" is indicated in EP—A—12663 and, as part of the addressing mechanism, in US—A—3428951 and comprises a latch and latch bypass pair. The theory is that initial speed of response is achieved by using the latch bypass alone the latch, itself, being disabled and subsequently set at some later time, after a delay 0, to lock the output. Thus such an arrangement presupposes two phase related clocks or an equivalent mechanism and the present invention seeks to retain the speed of output response while maintaining timing simplicity, producing, assuming realistic implementation, a simpler/cheaper circuit, since it has been appreciated that there is no need to incorporate any mechanism to handle the delay 0 since it can be made equal to "180°" and the memory will still work.

The present invention provides an integral memory circuit including storage elements, and time controlled addressing and output elements, the output elements comprising, for each bit output serving a set of storage elements, an output line connected both to a node common to the associated set of storage elements and also via a latch to the same node, so that the latch is by passed by the output line characterized in that time control of the time controlled elements is exercised by a single pulse train in such a way that the latches which subsequently hold the output line states are disabled for the periods during which all other of the time controlled elements are enabled.

In other words, the signal at the output sense node is communicated directly to an output driver without the circuit delay of an intermediate device or being subjected to a current drain that would also occasion a delay in achieving an output signal level at such output driver.

The circuit is further controlled by a single clock in contrast to the multiple clock inputs normally utilized, the single clock providing all the clock timing and synchronization for in the case of the described embodiment of a single chip FET read only memory circuit the entire memory chip including array, row and column select as well as restoring the memory matrix to an initial condition intermediate memory access cycles.

In the embodiment, the speed of the read only memory circuit is further enhanced in that as soon as the output sense node is at the proper level, the signal setting the latch may occur irrespective of whether the output line to the off chip driver has reached a steady state condition.

Reducing the number of clock signals required to perform the logical functions of the circuitry simplifies the timing, reduces the cost of clock drivers and reduces the complexity of the interface circuitry.

The circuitry of the embodiment also includes an output enable input which may be activated at any time to disable the off chip driver while not affecting the state of the output latch. This ability affords additional function such as bidirectional interface capability by allowing address inputs and data output to be OR-tied.

The present invention will be described further by way of example with reference to the aforesaid embodiment as illustrated in the drawings in which:—

Figure 1 is a schematic diagram of the embodiment;

Figure 2 (in sections A and B) is a circuit diagram of a part of the embodiment;

Figure 3 is a circuit diagram of block 14 of Figure 1;

Figure 4 is a circuit diagram of block 13 of Figure 1;

Figure 5 is a circuit diagram of block D1 of Figure 1; and

Figure 6 is an illustrative timing diagram.

The embodiment selected to illustrate the invention is a high density read only storage (ROS) circuit formed on a single large scale integration chip in field effect transistor technology. The matrix 11 of field effect transistors (FET) is formed as 384 columns and 288 rows of single device memory locations arranged, logically, as 6 arrays of 64 columns each. Each array consists of every sixth column, a column being defined by a common gate or word line each of which connects the real or hypothetical gate locations of one vertical column of memory locations or FET devices within the matrix. The arrays are accordingly interleaved within the matrix.

The matrix 11 is addressed by a 16 bit address which is identified as bits A0 to A15. A particular pattern of true and complement values of bits A0 to A5 connected to six NOR circuits 14 (one of which is shown in a general form) select the array. Address bit A5, as will be explained later, can be used to address the upper or lower halves of the matrix if it is desired to address a smaller size word. The six address bits A6 to A11 provide the word line select to select one word line or column within the 64 lines of the addressed array. Address bits A12 to A15 select the row or rows.

The word line or column select within an addressed array is identified by that one of the NOR circuit 12 which is timed to the presented pattern of bits A6 to A11, producing a significant output. The word line within the array is addressed by address bits A6 to A11.

Address bits A12 to A15 are decoded by 16 decode NOR circuits 13 (one of which is indicated in general form) which select one of the 16 lines in bus 15. The NOR circuits 17 are not utilized when a 18 bit word output from the memory is used and address A5 comprises one of a six bit address for array select. However, when it is desired to use 9 bit words, address bit A5 is used in true and complement form with NOR blocks 17 and AND blocks 19 to select the upper row select half 21 or lower half 22 of the row select bus 15 composed of lines 28 (appearing in Figure 2) and thereby the upper or lower halves of memory matrix 11. When a 9 bit word is sought, the array select is reduced to a 5 bit address or 32 unique combinations of true and complement values.

The output from the matrix of memory devices is sensed by a series of eighteen output elements D0 to D17. Each of the elements D0 to D17 senses the output with respect to sixteen rows of memory devices, one row of such devices associated with each of the sixteen row select lines. The output of the collection NOR 24 is connected directly to the output device (NOR 25) and output line 101 to off chip driver 26 without any circuit delay occasioned by the setting of the output sense latch (100) as will be explained with reference to Figure 5.

The matrix is organized with 384 columns and 288 rows of devices. In each of the blocks labelled 384 × 16 × 2, each of the sixteen row select lines 28 controls the line 29 (FIG. 2) which is connected to the drain electrodes of two adjoining rows of matrix FET memory devices and each of the two output sense amplifier/latch circuits includes a sixteen way collection NOR 24 the inputs of which are lines 30 each respectively connected to the source electrodes of one row of FET memory devices associated with each of the sixteen row lines 29. The blocks labelled 384 × 16 × 1 are similar except that each row line 29 is connected to the drain electrodes of one row of FET memory devices, and the single output sense amplifier latch circuit has a sixteen way NOR 24 that senses the presense of an output from all the memory devices of the block.

All the above circuits are part of a single large scale integration (LSI) chip formed on a single substrate. All the circuit functions on this memory chip are coordinated and driven by a single train of clock pulse signals on line 31 which is also labelled SET. This single pulse train controls the operation of the array select, word line decode, row select, output sense latch and the discharging of the array select lines between memory access cycles.

FIG. 2 shows a small portion of the matrix 11 including portions of twelve columns and seven rows memory location FET devices 33. The lines 28 are four of the sixteen row select lines that control lines 29 connected to the drain electrodes of rows devices 33 associated with the output sense amplifier latches D0 and D1. The selected row select line 28 controls a line 29 that, upon selection, provides a positive voltage to the drain electrode of the associated column selected FET devices 33 to cause the source line 30 connected thereto to be changed when and only when the selected memory location FET 33 is personalized with a gate element.

The array select NOR circuits 14 select one of the six lines 35 if the matrix is being addressed. The word line select is effected by a series of 32 decode NOR circuits 12 (one of which is shown) each in combination with a pair of decode doubler FET devices 36. Each decode NOR 12 identifies a group of twelve column gate lines 37, the decode doubler FET devices 36 select the group of six lines within the twelve and the array select lines 35 determines which of the FET devices 38 within the identified group of six will be activated and thereby apply a positive voltage +V to a single gate line 37 among the 384 of the matrix. The matrix 11 is personalized to two logic states during fabrication by selectively forming gates at the locations of FET devices 33. If a gate is present a first logical condition exists and if a gate is absent a second logical condition exists. If a gate is present at the selected FET memory location 33, a positive voltage will be transferred to the sense line 30 connected to the source electrode of the FET, and if a gate is absent no voltage charge will be transferred and the sense line will remain at ground potential.

FIG. 3 shows one of six array select circuits including the six devices 40 of the decode NOR 14 which have the gates thereof respectively attached to true or complement values of the address signals A0 through A5. If one of the six circuits (14) is selected all the signals applied to the gates of the FET devices 40 are at a down level causing a positive select voltage to be supplied at the output or array select line 35.

FIG. 4 shows one of sixteen decode circuits 13 for selecting one of sixteen row select lines 28. Each of the sixteen decode circuits has a unique combination of true and complement values of the address bits A12 through A15 respectively applied to the gates of FET devices 41 forming the NOR circuit 13. The selected row line decode circuit 13 (wherein the signals to all four FET gates 41 are at a down level) causes a positive voltage to appear on the output line 28 that in turn appears at the gate of the connected FET devices 42 (FIG. 2) causing the selected row drain lines 29 to become charged.

One of the eighteen output sense amplifier latches D0 through D17 is shown in FIG. 5. The FET devices 44, only some of which are shown, comprise a 16 way collection NOR circuit 24 wherein one sense line 30 is connected to each FET gate electrode. If the addressed memory location FET 33 in the matrix is personalized with a gate the transferred change causes the connected collection NOR FET 44 to become conductive grounding the line 45 and if a gate is not present at the memory location, the line 45 remains at a positive level. The depletion mode FET 46 functions as an amplifier to increase the performance of the memory circuit.

The condition at the node S is communicated directly to the gate of FET 48 and 59, to provide the sensed condition immediately to the line 49 (node X), which is connected to the off chip driver 26 without the circuit delays entailed in setting a latch. The latch is formed of a pair of cross connected FET devices 51, 52, a pair of load FET devices 54 and 55. When the set signal on the gate of device 56 goes high, the latch will be set to the condition of node S obtained just prior to such positive going signal. Devices 48, 57, 58, 59 function as a buffer driver and devices 60, 61 operate as an output enable. The output enable signal OE to the gates of devices 60, 61 may be brought to a positive level at any time to disable the off chip driver 26 while not affecting the state of the output sense latch.

SET on line 31 is an external clock signal (or train of pulses) required for the operation of all memory chip circuits. When the SET signal is at an up or positive level all row select drain lines 29, output sense source lines 30 and column select gate lines 37 in the matrix 11 are restored to ground potential. Further, with SET positive the communication of the gate or word line decode circuits, array select circuits and row select decode circuits with the matrix is disabled. When the set signal goes low, the memory is addressed and the output sense latch sense nodes S become valid which condition is communicated directly to output node X. When set goes positive or high, the latch composed of devices 51, 52, 54, 55 will be set to the condition of node S just prior to the SET transition from low to high. As long as SET remains high the latch will remain stable and set to the proper state. It will be appreciated that Figure 6 illustrates the case where the same low of address storage elements produces outputs of the same significance on successive accesses.

Such an arrangement achieves the desired logical function with a small number of devices which results in a correspondingly reduced required layout area. The circuit is a truly delayless latch scheme since setting the latch does not impede the transfer of information to the output by consuming power required to charge the gate of the off chip driver in order to force the latch to a desired state. Since, in effect, the latch is not present save when the SET signal on 31 is up, at which time, the output is already being supplied to driver 26, the latch serving to copy and hold that output. Setting the latch occurs for "free" in the sense that the external clock SET signal that feeds all other internal ROS circuits is utilized.

**Claims**

1. An integral memory circuit including storage elements (11), and time controlled addressing and output elements (12, 13, 14, 17, 31; D0 to D17, 31), the output elements comprising, for each bit output serving a set of storage elements, an output line (101) connected both to a node (S) common to the associated set of storage elements and also via a latch (100) to the same node, so that the latch is by passed by the output line characterized in that time control of the time controlled elements is exercised by a single pulse train (on 31) in such a way that the latches which subsequently hold the output line states are disabled for the periods during which all other of the time controlled elements are enabled.

2. A memory circuit as claimed in claim 1 characterized in that the circuit is realized in field effect transistor (FET) technology on a single substrate, each output latch comprising a pair of cross coupled FET's each having its own load FET, the corresponding node being coupled into one branch thereof between the latch and load FET's, a gate FET, gated by the timing pulse train, being inserted in that branch between the node and the latch FET whereby, in effect, no latch is present in one phase of the pulse train.

3. A memory circuit as claimed in claim 2 characterized in that each storage element is a single FET, the data content being defined by the presence or absence of a gate in the FET, a buffer driver circuit capable of isolating the output line and the latch being provided for each output line.

4. A memory circuit as claimed in claim 3 characterized in that each output line is coupled to an external driver and each buffer driver is coupled to an off substrate timing line.

**Revendications**

1. Circuit périphérique pour mémoire à semiconducteurs comprenant des éléments d'emmagasinage (11), des éléments d'adressage et des éléments de sortie commandés dans le temps (12, 13, 14, 17, 31; D0 à D17, 31), les éléments de sortie comportant, pour chaque sortie associée à un jeu d'éléments d'emmagasinage, une ligne de sortie (101) connectée à un noeud (S) commun au jeu d'éléments d'emmagasinage et connectée également, au moyen de la bascule bistable (100), au même noeud, de sorte que la bascule soit court-circuitée par la ligne de sortie, caractérisé en ce que la commande des éléments d'adressage et des éléments de sortie est réalisée au moyen d'un seul train d'impulsions (appliqué à l'élément 31) de façon que les bascules qui maintiennent l'état des lignes de sortie soient déconditionnées pendant les instants durant lesquels sont conditionnées tous les autres éléments commandés dans le temps.

2. Circuit selon la revendication 1, caractérisé en ce que le circuit est réalisé dans une technologie de transistors à effet de champ (FET) sur un seul substrat, chaque bascule de sortie comportant une paire de dispositifs FET couplés en croix ayant chacun son propre dispositif FET de charge, le noeud correspondant étant couplé à une de ses branches entre un des transistors de commutation FET de la bascule et le dispositif FET de charge associé, une porte FET commandée par les impulsions de chronologie étant insérée entre le noeud et le transistor FET de commutation de la bascule, ce qui a pour effet de mettre hors fonctionnement la bascule pendant une certaine phase du train d'impulsions.

3. Circuit selon la revendication 2, caractérisé en ce que chaque élément d'emmagasinage est formé d'un seul dispositif FET, le contenu des données étant défini par la présence ou l'absence d'une porte dans les dispositifs FET des éléments d'emmagasinage, un circuit d'attaque capable d'isoler la ligne de sortie et une bascule étant prévus pour chaque ligne de sortie.

4. Circuit selon la revendication 3, caractérisé en ce que chaque ligne de sortie est couplée à un organe d'attaque externe et chaque organe d'attaque est couplé à une ligne de chronologie hors substrat.

**Patentansprüche**

1. Monolithische Speicherschaltung mit Speicherelementen (11), zeitabhaengig gesteuerten Adressierungs- und Ausgabe-Elementen (12, 13, 14, 17, 31; D0, bis D17, 31), wobei die Ausgabe-Elemente fuer jede einem Satz von Speicherelementen zugeordnete Ausgabe eine Ausgabe-Leitung (101) aufweisen, die zugleich mit einem gemeinsamen Knotenpunkt (S) des jeweiligen Satzes von Speicherelementen und ueber eine Verriegelungsschaltung (100) mit dem gleichen Knotenpunkt verbunden ist, so dass die Verriegelungsschaltung von der Ausgabe-Leitung umgegangen ist, dadurch gekennzeichnet, dass die Steuerung der zeitabhaengig gesteuerten Elemente mittels einer einzelnen Impulsfolge (zu dem Element 31) so ausgefuehrt ist, dass die Verriegelungsschaltungen, die nachher die Zustaende der Ausgabe-Leitungen aufrechterhalten, entkoppelt sind, solange dass alle andere zeitabhaengig gesteuerte Elemente gekoppelt sind.

2. Speicherschaltung nach Anspruch 1, dadurch gekennzeichnet, dass die Schaltung auf einem einzelnen Substrat in der Feldeffekttransistor-Technik (FET) hergestellt ist, wobei jede Verriegelungsschaltung ein Paar von kreuzgekoppelten Feldeffekttransistoren jeweils mit seinem eigenen Lade-Feldeffekttransistor aufweist, der entsprechende Knotenpunkt mit einem Zweig der letzteren Verriegelungsschaltung zwischen dem Schaltfeldeffekttransistor un dem ihm zugeordneten Ladefeldeffekttransistor gekoppelt ist, ein von der Taktimpulsfolge gesteuertes FET-Gate in diesem Zweig zwischen dem Knotenpunkt und dem Schaltfeldeffekttransistor geschaltet ist, wodurch tatsaechlich in einer Phase der Impulsfolge die Verriegelungsschaltung nicht wirkt.

3. Speicherschaltung nach Anspruch 2, dadurch gekennzeichnet, dass jedes Speicherelement aus einem einzelnen Feldeffekttransistor besteht, wobei der Informationsinhalt so bestimmt ist, wenn ein Gate in dem Feldeffekttransistor vorliegt oder nicht, und eine Puffer-Treibschaltung, die die Ausgabe-Leitung und die Verriegelungsschaltung isolieren kann, bei jeder Ausgabe-Leitung vorgesehen ist.

4. Speicherschaltung nach Anspruch 3, dadurch gekennzeichnet, dass jede Ausgabe-Leitung mit einer externen Treibschaltung verbunden ist, und jede Puffer-Treibschaltung mit einer Taktleitung ausser dem Substrat verbunden ist.

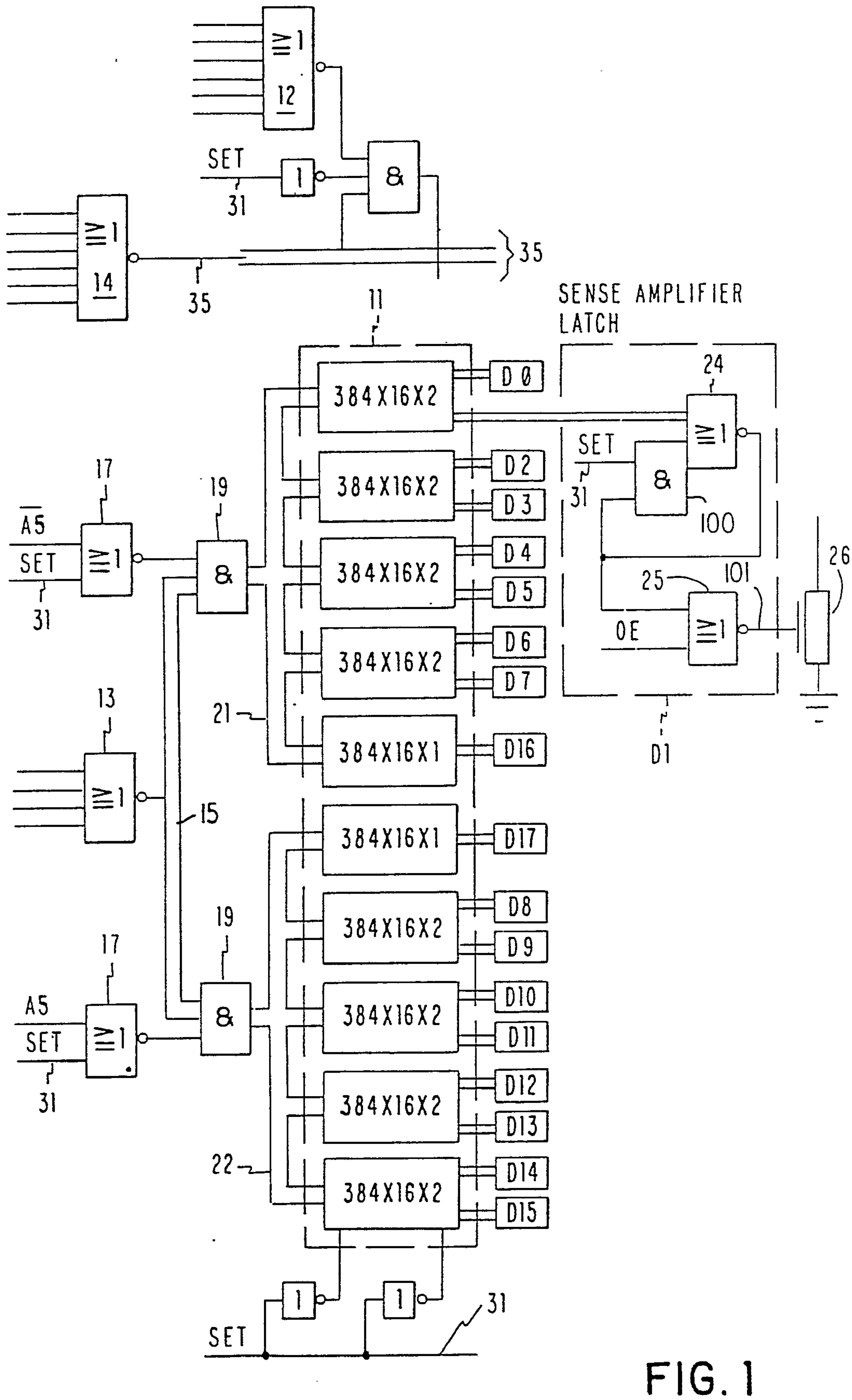
≧1
12
SET
31
1
&
≧1
14
35
35
11
SENSE AMPLIFIER
LATCH
384X16X2
D0
24
≧1
SET
31
&
100
D2
D3
D4
D5
25
101
26
OE
D6
D7
D1
21
384X16X1
D16
17
A5
SET
31
19
13
15
384X16X1
D17
D8
D9
D10
D11
D12
D13
D14
D15
22
SET
31

FIG. 1

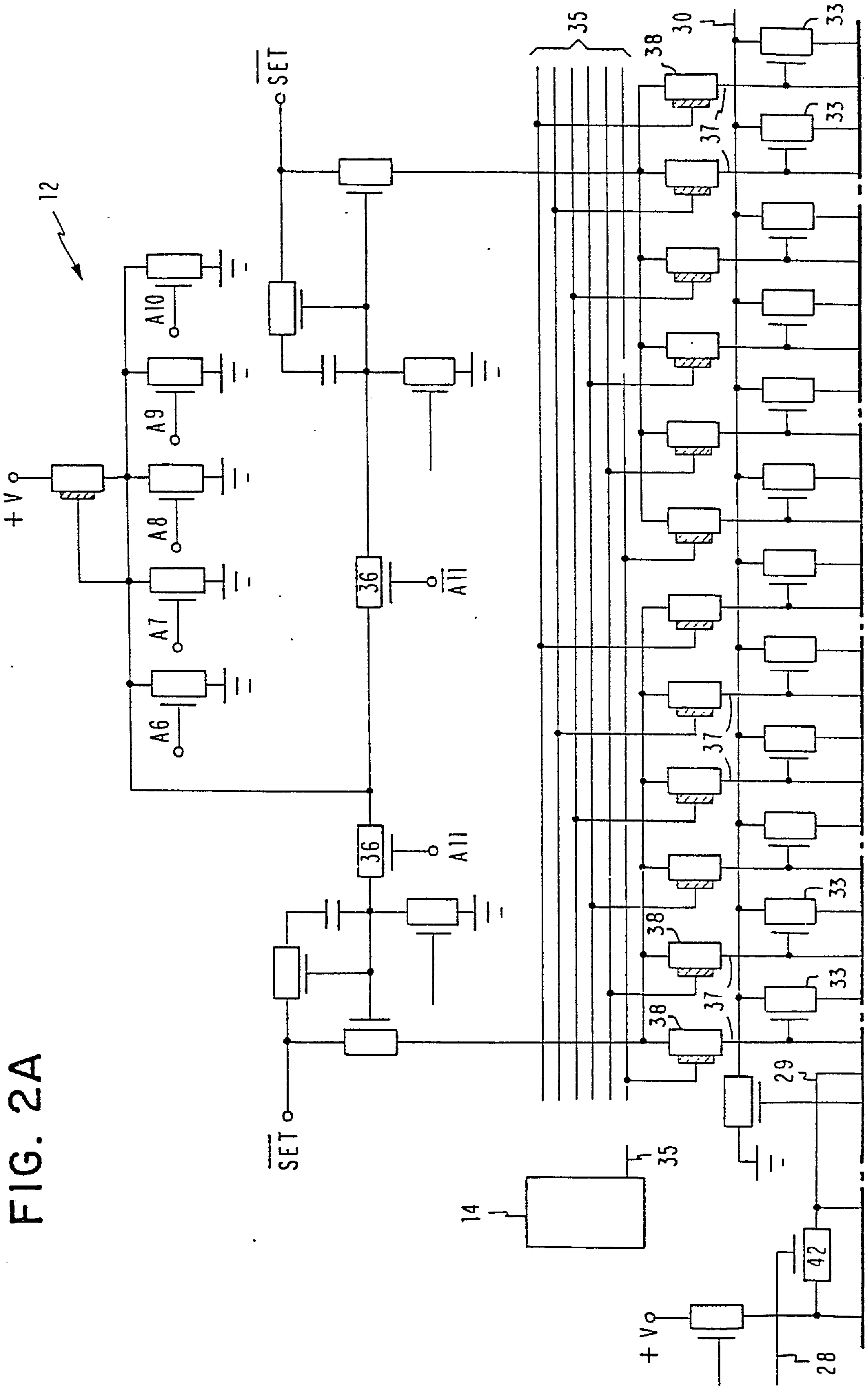


FIG. 2A

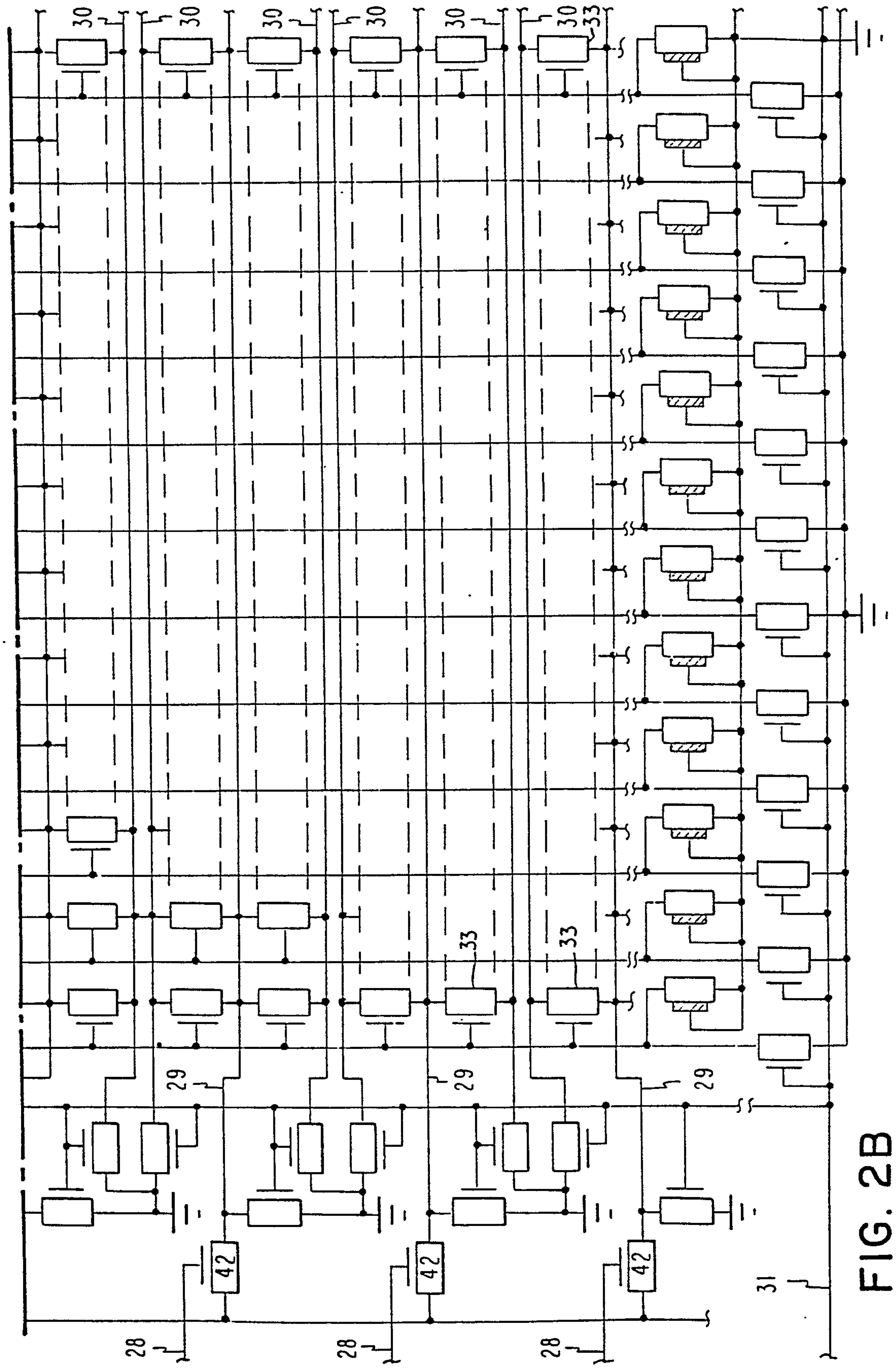


FIG. 2B

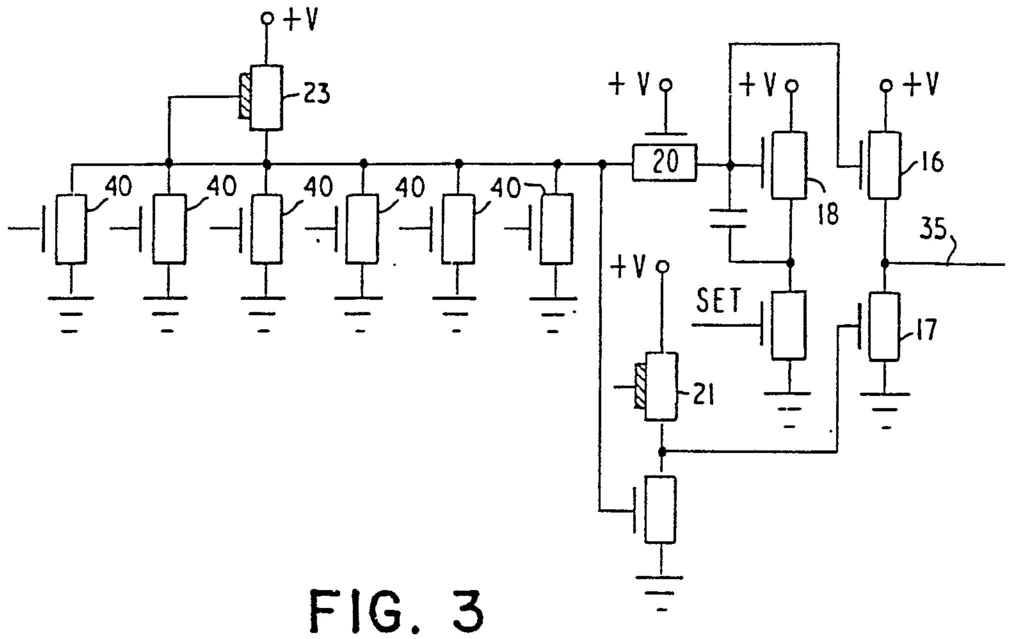


FIG. 3

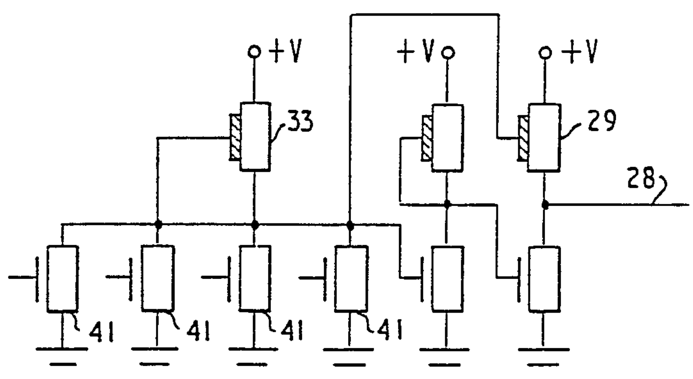


FIG. 4

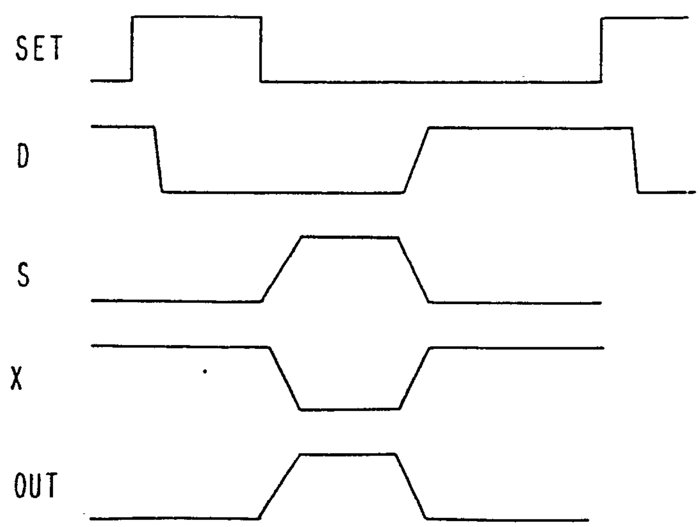


FIG. 6

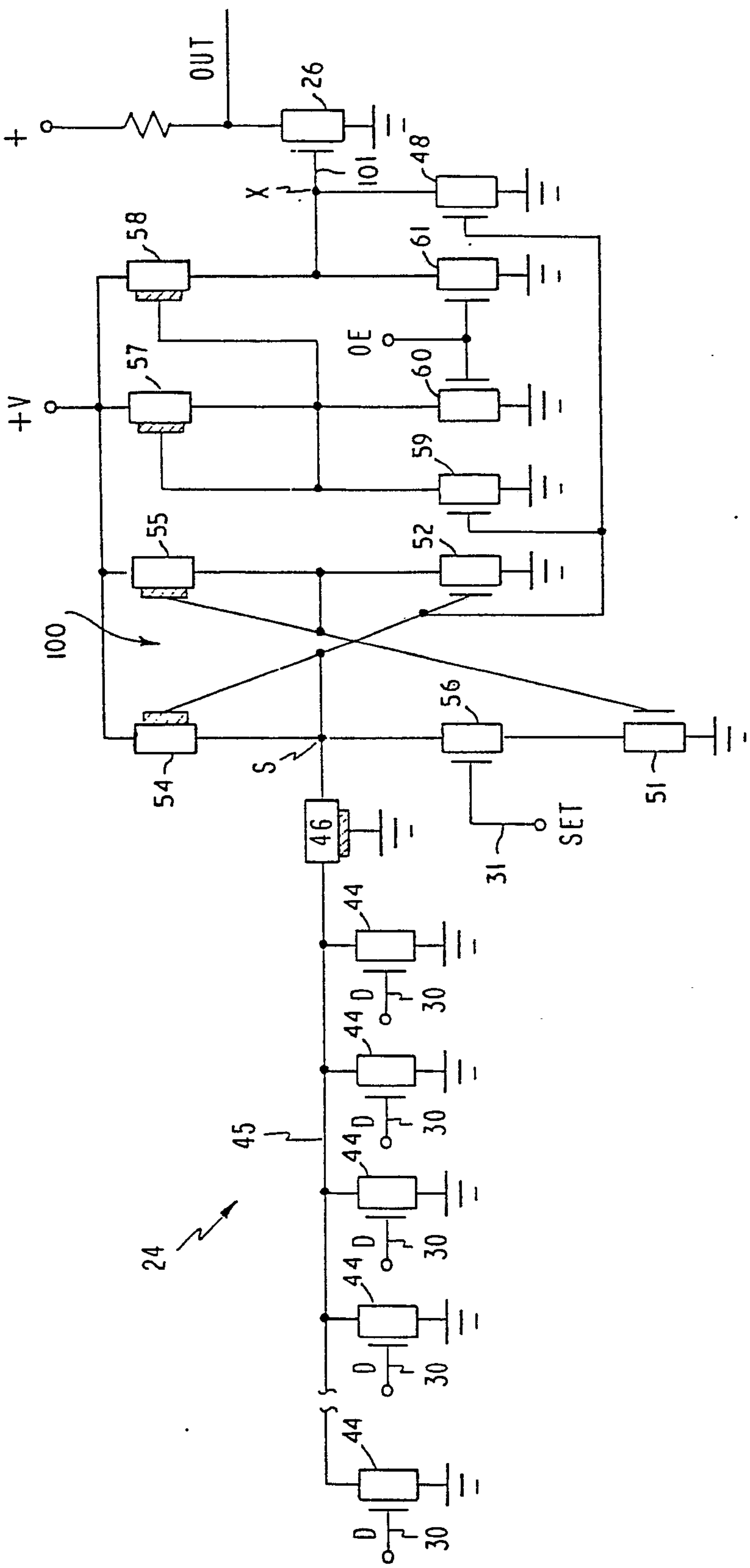
OUT
+
26
48
101
X
58
61
57
+V
OE
60
59
55
52
100
54
56
S
51
SET
31
46
44
D
30
45
24

FIG. 5